# EUROPÄISCHE PATENTSCHRIFT

(11) **EP 2 422 380 B1**
(45) Veröffentlichungstag und Bekanntmachung des Hinweises auf die Patenterteilung: **04.05.2016**
(21) Anmeldenummer: 10716807.2
(22) Anmeldetag: 20.04.2010
(51) Int. Cl.: H01L 41/047, H01L 41/09, F16K 31/00

(54) **PIEZOELEKTRISCHER ANTRIEB UND MIKROVENTIL MIT EINEM SOLCHEN**
PIEZOELECTRIC DRIVE AND MICROVALVE COMPRISING SAID DRIVE
ENTRAÎNEMENT PIÉZO-ÉLECTRIQUE ET MICRO-SOUPAPE L'UTILISANT

(30) Priorität: 24.04.2009 DE 102009002631
(43) Veröffentlichungstag der Anmeldung: 29.02.2012
(73) Patentinhaber: Lachner, Hubert, 85354 Freising-Hohenbachern (DE); Förg, Michael, 85354 Freising-Sünzhausen (DE)
(72) Erfinder: SCHWESINGER, Norbert, 98693 Ilmenau (DE); POBERING, Sebastian, 99096 Erfurt (DE); ZÄHRINGER, Sandy, 85221 Dachau (DE)
(74) Vertreter: Engel, Christoph Klaus
(86) Internationale Anmeldenummer: PCT/EP2010/055186
(87) Internationale Veröffentlichungsnummer: WO 2010/122016

(56) Entgegenhaltungen:
- EP-A1- 0 841 708
- JP-A- 1 041 283
- JP-A- 2007 095 988
- JP-Y2- H0 445 355
- HONG E ET AL: "Micromachined piezoelectric diaphragms actuated by ring shaped interdigitated transducer electrodes" SENSORS AND ACTUATORS A, Bd. 119, Nr. 2, 13. April 2005 (2005-04-13), Seiten 520-526, XP025325141 ISSN: 0924-4247 [gefunden am 2005-04-13]

## Beschreibung

Die vorliegende Erfindung betrifft einen piezoelektrischen Antrieb mit einer Verformungsschicht, welche auf einer Seite an eine piezoelektrische Schicht gekoppelt ist, die zur elektrischen Versorgung mit mindestens einem Elektrodenpaar aus zwei gegenpoligen Elektroden versehen ist. Ein solcher Antrieb eignet sich insbesondere aber nicht ausschließlich für die Verstellung eines Mikroventils, wobei dessen Membran die Verformungsschicht des piezoelektrischen Antriebs bildet.

Mikroventile und die zugehörigen Antriebe werden im Bereich der Mikrofluidik eingesetzt, um Flüssigkeits- oder Gasströme zu steuern. Die Mikroventile nehmen dabei üblicherweise nur einen geöffneten oder geschlossenen Zustand ein, sodass sie eine Ein-/Ausschaltfunktion erfüllen. Für die Steuerung einer Durchflussmenge können solche Mikroventile mit kurzen Zykluszeiten getaktet werden. Das Stellelement des Mikroventils wird dabei durch eine Membran gebildet, die bei entsprechender Auslenkung einen Ventilkanal freigibt bzw. schließt. Bei herkömmlichen Mikroventilen wird der Fluidweg durch den Ventilkanal normalerweise im nicht ausgelenkten Zustand der Membran unterbrochen. Zur Auslenkung der Membran ist ein Mikroantrieb erforderlich.

In der Mikrotechnik werden elektrostatische und piezoelektrische Antriebe verwendet. Piezoelektrische Antriebe basieren auf dem hinlänglich bekannten piezoelektrischen Prinzip, wobei durch Anlegen einer elektrischen Spannung an eine Piezokeramik eine Längenänderung im Material hervorgerufen wird. Bei der Nutzung des so genannten Längseffektes tritt eine als Antrieb nutzbare Verformung des Piezomaterials in einer Richtung auf, die mit der Richtung des elektrischen Feldes zwischen zwei gegenpoligen Elektroden übereinstimmt. Sogenannte Hochleistungspiezoelektrika (PZT), bei denen eine bezogen auf die Materialstärke relativ große Längenänderung feststellbar ist, basieren auf diesem Längseffekt, bei welchem die Polarisationsrichtung des Piezomaterials mit der elektrischen Feldrichtung übereinstimmt. Um beispielsweise eine Membran mit einem derartigen Antrieb zu bewegen, wird das Piezomaterial an einer Seite fest gelagert und an der anderen Seite mit der Membran verbunden.

Der erreichbare Verstellweg liegt bei diesen Anwendungen etwa bei 1/1000 der Dicke des Piezomaterials. Um einen mechanischen Hub von 1 µm zu erreichen, wird daher mindestens eine Piezomaterialdicke von 1 mm benötigt. Wenn ein größerer mechanischer Hub benötigt wird, steigt die Piezomaterialdicke entsprechend, was sich negativ für eine Anwendung dieser Antriebe in der Mikrotechnik auswirkt. Außerdem werden Ansteuerspannungen mit einer Feldstärke von etwa 3.000 V/mm zur Versorgung des Piezomaterials benötigt, die in mikrotechnischen Anwendungen schnell zu unerwünschten elektrischen Überschlägen führen können. Die für derartige Ansteuerspannungen benötigten Steuergeräte lassen sich in mikrotechnischen Lösungen kaum integrieren.

In der EP 0 914 563 B1 ist ein piezoelektrisch betätigtes Mikroventil beschrieben, welches sich den genannten piezoelektrischen Längseffekt zu Nutze macht. Dabei ist eine piezoelektrische Betätigungsvorrichtung an den Rahmen einer Aufhängungsvorrichtung gekoppelt. Die Aufhängungsvorrichtung trägt außerdem einen Stößel, der eine Durchlassöffnung im Ventil verschließt. Bei Spannungsbeaufschlagung der piezoelektrischen Betätigungsvorrichtung kommt es zu einer Längenänderung des Piezomaterials, die eine Verformung der Aufhängungsvorrichtung zur Folge hat, wodurch der Stößel senkrecht zur Längenänderung des Piezomaterials verschoben wird.

Piezoelektrische Materialien zeigen außerdem den so genannten Quereffekt, der eine Verformung des Piezomaterials senkrecht zur Richtung des elektrischen Feldes zwischen den Elektroden hervorruft. Beim Anlegen einer Spannung an das Piezomaterial zieht sich dieses quer zur Feldrichtung zusammen. Die durch den Quereffekt erreichbare Verformung ist in jedem Fall kleiner als 1/1000 der Piezomaterialausdehnung.

Die DE 36 18 107 A1 zeigt einen Tintenschreibkopf mit piezoelektrisch anregbarer Membran, wobei der Antrieb von dem erwähnten piezoelektrischen Quereffekt Gebrauch macht. Der Antrieb der Membran ist durch einen typischen Schichtenaufbau realisiert. Eine metallische Stützschicht ist an einem Grundsubstrat befestigt und erstreckt sich über eine flüssigkeitsführenden Kanalöffnung. Die metallische Stützschicht trägt eine polarisierte Schicht aus Piezokeramik auf der der Kanalöffnung abgewandten Seite. Die Stützschicht wirkt als Massenelektrode zum Aufbau des das Piezomaterial anregenden elektrischen Feldes. An der gegenüberliegenden Seite der Piezokeramik sind Ansteuerelektroden vorgesehen, welche eine lokal begrenzte Aktivierung des Piezomaterials ermöglichen. Das benötigte elektrische Feld baut sich somit zwischen der Massenelektrode und der jeweiligen Ansteuerelektrode auf, welche an gegenüberliegenden Seiten des Piezomaterials positioniert sind. Durch Ansteuerung der Elektroden kommt es zur Verformung der piezoelektrischen Keramikschicht und der daran befestigten metallischen Stützschicht, die als Membran wirkt. Durch die spezielle Anordnung der mehreren Ansteuerelektroden lässt sich eine Verformung der Stützschicht in Richtung zum Piezomaterial erreichen. Allerdings müssen dazu in bestimmten Bereichen Feldrichtungen aufgebaut werden, die entgegen der Polarisationsrichtung im Piezomaterial gerichtet sind. Ein Betrieb von Piezomaterial gegen die Polarisationsrichtung führt erfahrungsgemäß zu einer Entpolarisierung des Piezomaterials, was mittelfristig einen Verlust der piezoelektrischen Eigenschaften zur Folge hat. Problematisch ist außerdem, dass die metallische Stützschicht unmittelbar in Kontakt mit der Flüssigkeit in dem zu steuernden Kanal steht, was zur Korrosion der Stützschicht und zu elektrischen Problemen führen kann. Für viele mikrotechnische Anwendungen ist ein derartiger Aufbau daher nicht gewünscht.

Die US 6,222,304 B1 zeigt einen schalenförmigen Wandler, der beispielsweise zur Bewegung eines flüssigen oder festen Mediums ausgebildet sein kann. Ein elektroaktives Medium in Form einer piezoelektrischen Schicht ist z.B. über einer Pufferschicht aus ZrO₂ angeordnet, welche sich gemeinsam mit dem elektroaktiven Medium verformen soll. Das elektroaktive Medium wird durch zwei Elektroden bestromt.

Aus der US 5,255,016 ist ein Druckkopf für einen Tintenstrahldrucker bekannt. Der Druckkopf weist Vibrationsplatten auf, welche als Pumpen für die Tinte fungieren. Die Vibrationsplatten bestehen aus einem piezoelektrischen Material. Auf eine Oberfläche des piezoelektrischen Materials sind zwei Elektroden aufgebracht.

Die EP 0 841 708 A1 beinhaltet ein piezoelektrisches Element mit einem Aktuator umfassend einen vibrierenden Bereich und einen festen Bereich. Eine piezoelektrische Schicht ist direkt an den vibrierenden Bereich gekoppelt. An der dem vibrierenden Bereich abgewandten Seite der piezoelektrischen Schicht ist ein Elektrodenpaar angeordnet. Die Elektroden können beispielsweise als spirale Struktur ausgebildet sein.

In Hong E. u.a.: "Micromachined piezoelectric diaphragms actuated by ring shaped interdigitated transducer electrodes", SENSORS AND ACTUATORS A 119 (2005), S. 520-526, ist eine piezoelektrische Membran mit ringförmigen IDT Elektroden beschrieben. Die Elektroden sind auf einer Seite der piezoelektrischen Schicht angeordnet.

JP 2007 095988 A und JP H04 45355 Y2 lehren piezoelektrische Membran-Bauelemente mit Interdigitalelektroden bestehend aus radial angeordneten Fingern, die auf (einem äußeren Teilbereich) einer kreisförmigen Fläche angebracht sind.

Die Aufgabe der vorliegenden Erfindung besteht darin, einen piezoelektrischen Antrieb bereit zu stellen, der sich insbesondere für mikrotechnische Anwendungen eignet und die Ankopplung einer piezoelektrischen Schicht an eine Verformungsschicht, insbesondere eine Membran gestattet, welche keine Elektrodenfunktion für die Ansteuerung des Piezomaterials übernehmen muss. Eine Teilaufgabe besteht darüber hinaus darin, ein Mikroventil mit einer Membran bereit zu stellen, wobei die Membran bei Aktivierung einer angekoppelten piezoelektrischen Schicht mit nennenswertem Hub verformbar ist und gleichzeitig aus einem Material besteht, welches nicht die Funktion einer Elektrode für die piezoelektrische Schicht übernimmt.

Diese Aufgabe wird zunächst durch einen piezoelektrischen Antrieb mit den Merkmalen des beigefügten Anspruchs 1 gelöst. Dieser Antrieb zeichnet sich vor allem dadurch aus, dass die beiden gegenpoligen Elektroden, die für den Aufbau eines sich durch das piezoelektrische Material erstreckenden elektrischen Feldes benötigt werden, auf ein und derselben Seite der piezoelektrischen Schicht angebracht sind und zwar an der der Verformungsschicht abgewandten Seite der piezoelektrischen Schicht. Die herkömmliche Schichtenstruktur, bei welcher die piezoelektrische Schicht zwischen zwei Elektrodenschichten eingeschlossen ist, wird erfindungsgemäß aufgegeben. Durch die Anordnung der gegenpoligen Elektroden auf einer gemeinsamen Seite der piezoelektrischen Schicht kommt es zu einer Überlagerung von Längs- und Quereffekt, die eine flächenhafte Dehnung der piezoelektrischen Schicht zur Folge hat.

Eine bevorzugte Ausführungsform zeichnet sich dadurch aus, dass die Elektroden die piezoelektrische Schicht im Wesentlich vollständig bedecken. Insbesondere ist es zweckmäßig, wenn die äußere Begrenzung der piezoelektrischen Schicht im Wesentlichen deckungsgleich mit der äußeren Begrenzung der aufgebrachten Elektroden ist. Es hat sich nämlich gezeigt, dass die gewünschte, nach außen gerichtete Verformung der piezoelektrischen Schicht, die auf der den Elektroden gegenüberliegenden Seite an die Verformungsschicht übertragen werden kann, vorwiegend in Bereichen entsteht, die von den Elektroden bedeckt sind. In Bereichen, die entfernt von den Elektroden liegen, lässt die nach außen gerichtete Verformung der piezoelektrischen Schicht zunehmend nach. Bevorzugte Ausführungsformen besitzen daher eine piezoelektrische Schicht, die nicht mehr als die doppelte Breite der äußeren Elektrode über die von den Elektrodenstrukturen bedeckte Fläche hinausreicht. Ebenso ist es zweckmäßig, wenn die zwischen den gegenpoligen Elektroden verbleibenden Flächen, die nicht von einer Elektrode bedeckt sind, nicht größer als die durchschnittliche doppelte Breite der angrenzenden Elektroden ist. Es ist darauf hinzuweisen, dass die an der gegenüberliegenden Seite der piezoelektrischen Schicht angebrachte Verformungsschicht natürlich flächenmäßig größer sein kann als die piezoelektrische Schicht bzw. die von den Elektroden bedeckte Fläche.

Die Verformungsschicht kann vorzugsweise aus nicht elektrisch leitfähigem Material bestehen, da sie keine Elektrodenfunktion übernehmen muss. Damit kann an die Verformungsschicht auch mit aggressiven Medien in Kontakt kommen, ohne dass eine Korrosion der Elektroden befürchtet werden muss.

Bei Ansteuerung der Elektroden in Polarisationsrichtung dehnt sich die piezoelektrische Schicht aus, so dass eine daran angekoppelte Verformungsschicht oder Membran je nach Gestaltung der Elektroden entweder in Richtung zur piezoelektrischen Schicht oder auch von dieser weg verformt wird.

Die oben genannte Aufgabe wird darüber hinaus durch ein Mikroventil gemäß dem beigefügten Anspruch 8 gelöst. Die Membran des Mikroventils bildet zugleich die Verformungsschicht des genannten piezoelektrischen Antriebs. Durch die erwähnte Ausdehnung der piezoelektrischen Schicht bei Ansteuerung der Elektroden kann die Membran einen Ventilkanal bzw. Fluidweg freigeben und beim Abschalten der Versorgungsspannung sperren. Durch die Anordnung der Elektroden ist außerdem sichergestellt, dass sie nicht mit dem im Mikroventil geführten Fluid in Kontakt kommen.

Die gegenpoligen Elektroden können unterschiedlich strukturiert sein, wobei sie vorzugsweise in Form zahlreicher, nebeneinander verlaufender Streifen mit alternierender Polarität ausgebildet sind. Bei kreisförmigen piezoelektrischen Schichten verlaufen die Elektroden erfindungsgemäß strahlenförmig in radialer Richtung. Um einen möglichst gleichförmigen Feldstärkenverlauf zu erhalten, verlaufen dabei zahlreiche Elektrodenabschnitte im Wesentlichen parallel zueinander.

Bei einer bevorzugten Ausführungsform ist die piezoelektrische Schicht unmittelbar auf der Verformungsschicht aufgebracht. Dies gestattet eine verlustfreie Kraftübertragung und ermöglicht die Herstellung des piezoelektrischen Antriebs durch Verwendung von in der Mikrotechnik üblichen Verfahren. Weitere Vorteile, Einzelheiten und Weiterbildungen der vorliegenden Erfindung ergeben sich aus der nachfolgenden Beschreibung bevorzugter Ausführungsformen, unter Bezugnahme auf die Zeichnungen. Es zeigen:
- Fig. 1: eine prinzipielle Querschnittsansicht des Grundaufbaus eines erfindungsgemäßen piezoelektrischen Antriebs;
- Fig. 2: eine schematische Draufsicht auf eine piezoelektrische Schicht des Antriebs mit strahlenförmigem Verlauf von Elektroden, wobei eine der Elektrodengruppen über einen im Zentrum liegenden Anschluss kontaktiert ist;
- Fig. 3: eine schematische Draufsicht auf eine ähnliche Ausfüh-rungsform der Elektrodenanordnung an der piezoelektri-schen Schicht mit zwei im Außenbereich kontaktierten Elektrodengruppen;
- Fig. 4: eine schematische Draufsicht auf eine erfindungsgemäße Ausfüh-rungsform der Elektrodenstruktur mit parallel zueinan-der verlaufenden Streifenelektroden;
- Fig. 5: eine schematische Draufsicht einer Ausfüh-rungsform der Elektrodenstruktur der piezoelektrischen Schicht mit streifenförmigen und keilförmigen Elektro-den;
- Fig. 7: zwei prinzipielle Schnittansichten eines Mikroventils mit dem erfindungsgemäßen piezoelektrischen Antrieb in einer geöffneten und einer geschlossenen Stellung.

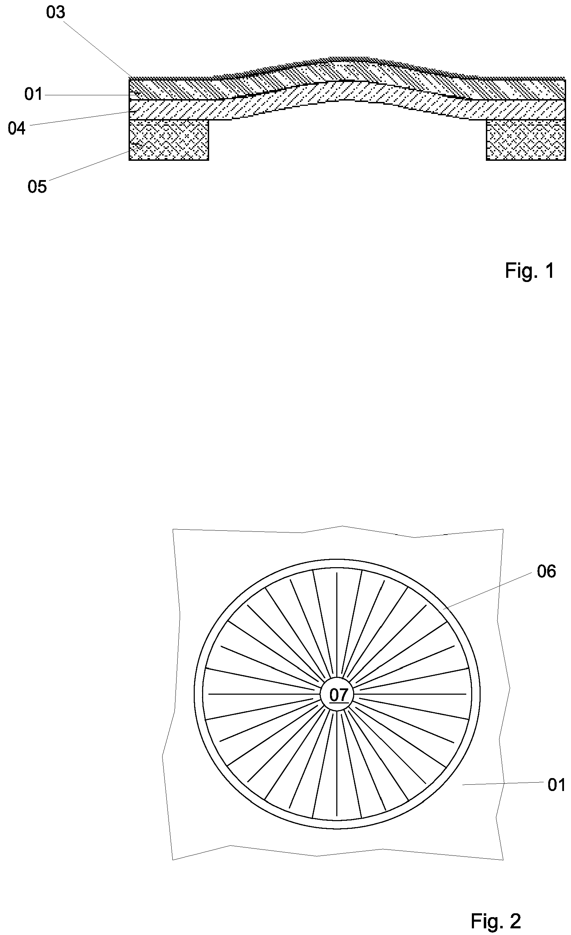

In Fig. 1 ist der prinzipielle Aufbau eines erfindungsgemäßen piezoelektrischen Antriebs im Querschnitt gezeigt. Als aktives Antriebselement agiert eine piezoelektrische Schicht 01, die an ihrer Oberseite mindestens ein gegenpoliges Elektrodenpaar 03 zur Beaufschlagung mit einer Versorgungsspannung trägt. Es ist darauf hinzuweisen, dass ein wesentlicher Aspekt der Erfindung darin zu sehen ist, dass beide das Elektrodenpaar 03 bildende Elektroden an einer gemeinsamen Seite der piezoelektrischen Schicht angeordnet sind. Ein wie im Stand der Technik gegenüberliegendes Elektrodenpaar ist hier nicht vorgesehen. Vielmehr ist im dargestellten Beispiel an der den Elektroden abgewandten Seite der piezoelektrischen Schicht 01 unmittelbar eine Membran 04 angeordnet, die eine Verformungsschicht des Antriebs bildet. Die Elektroden sind bevorzugt als Gruppen aus zahlreichen Einzelelektrodenstreifen gebildet, die alternierend auf der zu aktivierenden Fläche der piezoelektrischen Schicht angebracht sind.

Die Membran 04 ist in ihrem Randbereich an einer Membranauflage 05 befestigt, die beispielsweise ringförmig gestaltet ist. Soweit der piezoelektrische Antrieb nicht in einem Mikroventil eingesetzt wird, können über die Verformungsschicht 04 andere Antriebsaufgaben erfüllt werden, beispielsweise die Positionierung eines optischen Elements.

Der piezoelektrische Antrieb ist in Fig. 1 in einem aktivierten Zustand dargestellt, d. h. über das Elektrodenpaar 03 wird die piezoelektrische Schicht 01 mit einer Versorgungsspannung beaufschlagt, wodurch eine flächenhafte Dehnung der piezoelektrischen Schicht 01 hervorgerufen wird. Dies führt zu einer Verformung der piezoelektrischen Schicht und der daran angekoppelten Membran 04 bzw. Verformungsschicht in Richtung zur piezoelektrischen Schicht. Diese Verformung wird durch Erzeugung eines inhomogenen elektrischen Feldes erreicht, welches aufgrund einer speziellen Strukturierung bzw. Anordnung der Elektroden aufgebaut wird. Dafür werden nachfolgend bevorzugte Ausführungsformen beschrieben. Es wird jedoch darauf hingewiesen, dass durch veränderte Anordnung zueinander und Strukturierung der Elektroden auch eine Verformung der piezoelektrischen Schicht und der daran angekoppelten Membran bzw. Verformungsschicht in entgegen gesetzter Richtung, also hin zur Verformungsschicht erreichbar ist, was ebenfalls im Rahmen der vorliegenden Erfindung liegt.

Fig. 2 zeigt in einer schematischen Draufsicht eine erste bekannte Ausführungsform der prinzipiellen Strukturierung des Elektrodenpaars an der Oberseite der piezoelektrischen Schicht 01. Die zahlreichen Elektroden verlaufen hier als gerade Streifen im Wesentlichen radial zwischen dem Zentrum und dem Rand der piezoelektrischen Schicht 01 und der darunter liegenden Membran 04. Die Elektroden sind zu zwei Gruppen unterschiedlicher Polarität zusammengefasst und können damit elektrisch als zwei in Abschnitte zergliederte Elektroden betrachtet werden. Jeder Elektrode erster Polarität liegt eine Elektrode zweiter Polarität gegenüber, sodass ein elektrisches Feld entsteht, wenn eine Versorgungsspannung angelegt wird. Aufgrund der Verteilung der einzelnen Elektroden ist dieses Feld weitgehend inhomogen. Die Elektroden bestehen aus elektrisch gut leitfähigem Material und können durch in der Mikrotechnik übliche Verfahren hergestellt werden.

Die aktive Fläche der piezoelektrischen Schicht 01 ist bei der in Fig. 2 gezeigten Ausführung kreisförmig ausgebildet, wobei der äußere Rand des aktiven Bereichs durch die darunter liegende Membranauflage 05 (Fig. 1) definiert ist, an welcher die Membran 04 eingespannt ist. Die ersten Elektroden des Elektrodenpaars 03 gehen von einer äußeren, kreisförmigen Kontaktierungsstelle 06 aus und die zweiten Elektroden gehen von einer im Zentrum der piezoelektrischen Schicht 01 angeordneten zweiten Kontaktierungsstelle 07 aus. Der minimale Elektrodenabstand zwischen den gegenpoligen Elektroden muss an jeder Stelle so groß sein, dass ein elektrischer Überschlag bei den verwendeten Versorgungsspannungen vermieden wird. Durch Erhöhung der alternierenden Elektrodenzahl und damit einhergehender Reduzierung des Elektrodenabstands kann die erforderliche Versorgungsspannung reduziert werden.

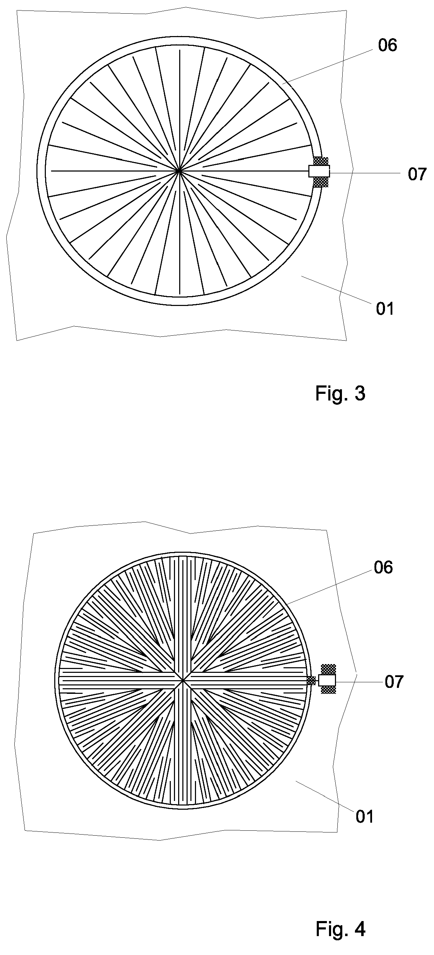

Fig. 3 zeigt eine ähnliche bekannte Ausführungsform der Strukturierung der Elektroden auf der piezoelektrischen Schicht 01. Bei dieser Ausführung verläuft die erste Kontaktierungsstelle 06 wiederum kreisförmig am äußeren Rand des aktiven Bereichs der piezoelektrischen Schicht 01. Die zweite Kontaktierungsstelle 07 ist vom Zentrum weg ebenfalls in den äußeren Randbereich verlagert. Von der zweiten Kontaktierungsstelle 07 wird das angelegte Spannungspotential zum Zentrum geführt und von dort an die mehreren zweiten Elektroden verteilt, die wiederum strahlenförmig nach außen und alternierend zu den ersten Elektroden verlaufen.

Fig. 4 zeigt eine erfindungsgemäße Ausführungsform strukturierter Elektroden auf der piezoelektrischen Schicht 01. Anders als bei den beiden zuvor beschriebenen Ausführungsformen, bei denen die elektrischen Feldstärken zwischen den Elektroden vom Zentrum zum äußeren Rand hin aufgrund des größer werdenden Elektrodenabstandes abnehmen, können hier im wesentlichen gleich bleibende Feldstärken generiert werden. Dazu werden parallel verlaufende Streifenelektroden verwendet, die wiederum über erste und zweite Kontaktierungsstellen 06, 07 an die Versorgungsspannung angelegt werden. Durch die Vielzahl der Elektrodenstreifen kommt es beim Anlegen der Versorgungsspannung zu einer piezoelektrischen Reaktion der unter den Elektroden liegenden Piezomaterialschicht. Aufgrund der Interaktionen zwischen piezoelektrischen Längs- und Quereffekt wird unter den Elektroden eine Flächendehnung hervorgerufen.

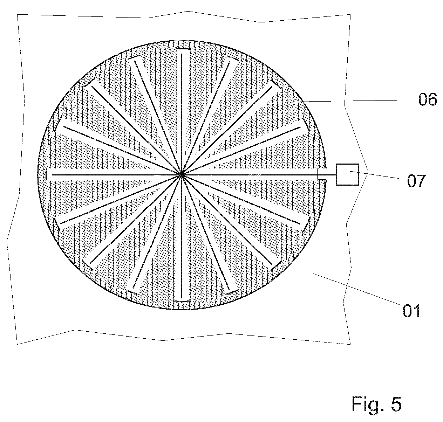

Fig. 5 zeigt eine den Fig. 2 und 3 ähnliche Ausführungsform der Elektrodenstruktur, bei welcher sich die gegenpoligen Elektroden wiederum an parallelen Grenzflächen gegenüberstehen. Dazu sind streifenförmige erste Elektroden ausgebildet, die mit der ersten Kontaktierungsstelle 06 verbunden sind, und zwischenliegende keilförmige zweite Elektroden, die mit der zweiten Kontaktierungsstelle 07 verbunden sind.

Sofern anstelle einer piezoelektrischen Schicht und einer darunter liegenden kreisförmigen Membran eine andere Membrangeometrie bevorzugt wird, muss die Elektrodenstruktur angepasst werden. Es können ebenfalls streifenförmige Elektroden eingesetzt werden, die auf der aktiven Fläche der piezoelektrischen Schicht zu verteilen sind.

Durch die erfindungsgemäße Anordnung beider Elektrodengruppen auf ein und derselben Seite der piezoelektrischen Schicht kann ein inhomogenes elektrisches Feld aufgebaut werden. Diese inhomogene Feldverteilung führt zu unterschiedlichen Dehnungen und Kontraktionen im gesamten vom Feld durchdrungenen Bereich der piezoelektrischen Schicht. Wenn die Elektroden in der beschriebenen Weise angeordnet werden, dominiert der Längseffekt im Piezomaterial, was zu einer Dehnung dieser Gebiete führt. Die Dicke des piezoelektrischen Materials spielt dabei nur eine untergeordnete Rolle, denn das erzeugte elektrische Feld dringt nur in geringe Tiefen des Piezomaterials vor, so dass in den nicht vom elektrischen Feld beeinflussten Materialbereichen kaum piezoelektrische Effekte auftreten.

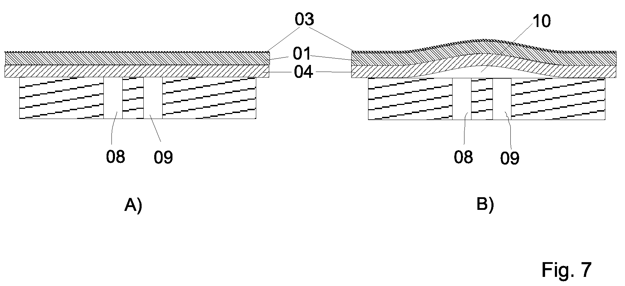

Fig. 7 zeigt zwei Querschnittsansichten des prinzipiellen Aufbaus eines Mikroventils, welches den zuvor erläuterten piezoelektrischen Antrieb verwendet. In der Abb. A) ist das Mikroventil im geschlossenen Zustand gezeigt, während Abb. B) den geöffneten Zustand des Ventils zeigt. Die Membran 04 und die daran angebrachte piezoelektrische Schicht 01 überdecken einen Zulaufkanal 08 und einen Ablaufkanal 09 des Ventils. Im geschlossenen Zustand sind beide Kanäle durch die Membran 04 verschlossen, so dass kein Fluid zwischen dem Zulaufkanal und dem Ablaufkanal strömen kann. Bei Aktivierung der piezoelektrischen Schicht 01 kommt es zur beschriebenen Flächendehnung, so dass sich die Membran 04 in Richtung zur piezoelektrischen Schicht 01 wölbt und damit die Kanäle 08, 09 freigibt. Ein zu steuerndes Fluid kann dann zwischen den Kanälen über einen sich ausbildenden Ventilraum 10 strömen.

Für den Fachmann ist ersichtlich, dass unter Verwendung des erfindungsgemäßen piezoelektrischen Antriebs unterschiedliche Mikroventile aufgebaut werden können. Ebenso ist der piezoelektrische Antrieb für andere Antriebsfälle einsetzbar.

### Bezugszeichenliste

- 01: piezoelektrische Schicht
- 02: -
- 03: Elektrodenpaar
- 04: Membran / Verformungsschicht
- 05: Membranauflage
- 06: erste Kontaktierungsstelle
- 07: zweite Kontaktierungsstelle
- 08: Zulaufkanal
- 09: Ablaufkanal
- 10: Ventilraum

## Patentansprüche

1. Piezoelektrischer Antrieb, insbesondere für Mikroventile, umfassend eine Verformungsschicht (04), welche auf einer Seite an eine piezoelektrische Schicht (01) gekoppelt ist, die zur elektrischen Versorgung mit mindestens einem Elektrodenpaar (03) aus zwei gegenpoligen Elektroden versehen ist, wobei die beiden gegenpoligen Elektroden des Elektrodenpaars (03) gemeinsam an der der Verformungsschicht (04) abgewandten Seite der piezoelektrischen Schicht (01) angeordnet sind, **dadurch gekennzeichnet, dass** die gegenpoligen Elektroden innerhalb einer kreisförmigen Fläche als radial verlaufende Streifen alternierender Polarität angeordnet sind, die zahlreiche parallel zueinander verlaufende Elektrodenabschnitte besitzen.

2. Piezoelektrischer Antrieb nach Anspruch 1 , **dadurch gekennzeichnet, dass** die Verformungsschicht (04) aus einem elektrisch nicht leitenden Material besteht.

3. Piezoelektrischer Antrieb nach Anspruch 1 oder 2, **dadurch gekennzeichnet, dass** die beiden gegenpoligen Elektroden derart strukturiert sind, dass beim Anlegen einer Spannung eine Verformung der piezoelektrischen Schicht (01) in zur Lage der Verformungsfläche (04) entgegen gesetzten Richtung resultiert.

4. Piezoelektrischer Antrieb nach einem der Ansprüche 1 bis 3, **dadurch gekennzeichnet, dass** zahlreiche gegenpoligen Elektroden parallel zueinander verlaufend auf der der Verformungsschicht (04) abgewandten Seite der piezoelektrischen Schicht (01) angebracht sind.

5. Piezoelektrischer Antrieb nach einem der Ansprüche 1 bis 4, **dadurch gekennzeichnet, dass** zahlreiche gegenpoligen Elektroden so auf der der Verformungsschicht (04) abgewandten Seite der piezoelektrischen Schicht (01) angebracht sind, dass sich ein inhomogenes elektrisches Feld im oberflächennahen Bereich der piezoelektrischen Schicht (01) ausbildet.

6. Piezoelektrischer Antrieb nach einem der Ansprüche 1 bis 5, **dadurch gekennzeichnet, dass** sich die von den gegenpoligen Elektroden bedeckte Fläche im Wesentlichen bis zum äußeren Rand der piezoelektrischen Schicht (01) erstreckt.

7. Piezoelektrischer Antrieb nach einem der Ansprüche 1 bis 6, **dadurch gekennzeichnet, dass** die piezoelektrische Schicht (01) unmittelbar an der Verformungsschicht (04) angebracht ist.

8. Mikroventil mit mindestens einem Ventilkanal (08, 09) und einer den Ventilkanal öffnenden oder schließenden Membran (04), **dadurch gekennzeichnet, dass** die Membran (04) zugleich die Verformungsschicht eines piezoelektrischen Antriebs nach einem der Ansprüche 1 bis 7 bildet.

9. Mikroventil nach Anspruch 8, **dadurch gekennzeichnet, dass** die Membran (04) bei nicht aktiviertem piezoelektrischen Antrieb im nicht verformten Zustand ist und den Ventilkanal (08, 09) verschließt und zur Öffnung des Ventilkanals von diesem weg verformt wird durch Aktivierung des Antriebs.

10. Mikroventil nach Anspruch 9, **dadurch gekennzeichnet, dass** die piezoelektrische Schicht (01) des Antriebs auf der dem Ventilkanal (08, 09) abgewandten Seite der Membran (04) angeordnet ist.

## Claims

1. Piezoelectric drive, particularly for microvalves, comprising a deformation layer (04) which is coupled on one side to a piezoelectric layer (01), which is provided for the electrical power supply with at least one pair of electrodes (03) made of two electrodes of opposite polarities, whereas the two electrodes of opposite polarities of the pair of electrodes (03) are arranged together on the side of the piezoelectric layer (01) facing away from the deformation layer (04), **characterized in that** the electrodes of opposite polarities are arranged within a circular surface as radially extending strips with alternating polarity, having numerous electrode segments extending parallel to each other.

2. Piezoelectric drive according to Claim 1, **characterized in that** the deformation layer (04) consists of an electrically nonconductive material.

3. Piezoelectric drive according to Claim 1 or 2, **characterized in that** the two electrodes of opposite polarities are structured in such a manner that when voltage is applied, a deformation of the piezoelectric layer (01) in a direction opposite the position of the deformation surface (04) results.

4. Piezoelectric drive according to one of Claims 1 to 3, **characterized in that** numerous electrodes of opposite polarities extend parallel to each other on the side of the piezoelectric layer (01) facing away from the deformation layer (04).

5. Piezoelectric drive according to one of Claims 1 to 4, **characterized in that** numerous electrodes of opposite polarities are applied on the side of the piezoelectric layer (01) facing away from the deformation layer (04), in such a manner that an inhomogeneous electrical field forms in the surface-near area of the piezoelectric layer (01).

6. Piezoelectric drive according to one of Claims 1 to 5, **characterized in that** the surface covered by the electrodes of opposite polarities extends substantially to the outer margin of the piezoelectric layer (01).

7. Piezoelectric drive according to one of Claims 1 to 6, **characterized in that** the piezoelectric layer (01) is applied directly on the deformation layer (04).

8. Microvalve having at least one valve channel (08, 09) and a membrane (04) which opens or closes the valve channel, **characterized in that** the membrane (04) at the same time forms the deformation layer of a piezoelectric drive according to one of claims 1 to 7.

9. Microvalve according to Claim 8, **characterized in that**, when the piezoelectric drive is not activated, the membrane (04) is in the undeformed state and closes the valve channel (08, 09) and, for opening the valve channel, it is deformed away from said channel by the activation of the drive.

10. Microvalve according to Claim 9, **characterized in that** the piezoelectric layer (01) of the drive is arranged on the side of the membrane (04) facing away from the valve channel (08, 09).

## Revendications

1. Entraînement piézoélectrique, en particulier pour micro-valves, comprenant une couche de déformation (04) qui est couplée d'un côté à une couche piézoélectrique (01) laquelle, pour l'alimentation électrique, est dotée d'au moins une paire d'électrodes (03) à base de deux électrodes à pôles opposés, dans lequel les deux électrodes à pôles opposés de la paire d'électrodes (03) sont disposées ensemble sur le côté, tournant le dos à la couche de déformation (04), de la couche piézoélectrique (01), **caractérisé en ce que** les électrodes à pôles opposés sont disposées à l'intérieur d'une surface circulaire en tant que bandes s'étendant radialement à polarité alternant, lesquelles possèdent une pluralité de segments d'électrode s'étendant parallèlement entre eux.

2. Entraînement piézoélectrique selon la revendication 1, **caractérisé en ce que** la couche de déformation (04) se compose d'un matériau non électroconducteur.

3. Entraînement piézoélectrique selon la revendication 1 ou 2, **caractérisé en ce que** les deux électrodes à pôles opposés sont structurées d'une manière telle, qu'en cas d'application d'une tension, il en résulte une déformation de la couche piézoélectrique (01) dans la direction opposée à la position de la surface de déformation (04).

4. Entraînement piézoélectrique selon l'une des revendications 1 à 3, **caractérisé en ce qu'**une pluralité d'électrodes à pôles opposés sont placées de manière à s'étendre parallèlement les unes aux autres sur le côté, tournant le dos à la couche de déformation (04), de la couche piézoélectrique (01).

5. Entraînement piézoélectrique selon l'une des revendications 1 à 4, **caractérisé en ce qu'**une pluralité d'électrodes à pôles opposés sont placées sur le côté, tournant le dos à la couche de déformation (04), de la couche piézoélectrique (01) d'une manière telle, qu'un champ électrique non homogène se forme dans la zone proche de la surface de la couche piézoélectrique (01).

6. Entraînement piézoélectrique selon l'une des revendications 1 à 5, **caractérisé en ce que** la surface recouverte par les électrodes à pôles opposés s'étend sensiblement jusqu'au bord extérieur de la couche piézoélectrique (01).

7. Entraînement piézoélectrique selon l'une des revendications 1 à 6, **caractérisé en ce que** la couche piézoélectrique (01) est placée directement sur la couche de déformation (04).

8. Micro-valve avec au moins un canal de valve (08, 09) et une membrane (04) ouvrant et fermant le canal de valve, **caractérisée en ce que** la membrane (04) forme simultanément la couche de déformation d'un entraînement piézoélectrique selon l'une des revendications 1 à 7.

9. Micro-valve selon la revendication 8, **caractérisée en ce que** la membrane (04) est à l'état non déformé en cas de non activation de l'entraînement piézoélectrique et ferme le canal de valve (08, 09) et **en ce que**, pour l'ouverture du canal de valve, elle est déformée en éloignement de celui-ci par activation de l'entraînement.

10. Micro-valve selon la revendication 9, **caractérisée en ce que** la couche piézoélectrique (01) de l'entraînement est disposée sur le côté, tournant le dos au canal de valve (08, 09), de la membrane (04).
